Europäisches Patentamt

European Patent Office

Office européen des brevets

(11) Numéro de publication: **0 314 543**

**A1**

## (12) DEMANDE DE BREVET EUROPEEN

(21) Numéro de dépôt: 88402610.5

(22) Date de dépôt: 14.10.88

(51) Int. Cl.4: **H 01 T 1/00**
**H 02 H 9/06**

(30) Priorité: 23.10.87 FR 8714669

(43) Date de publication de la demande:
03.05.89 Bulletin 89/18

(84) Etats contractants désignés: DE ES GB IT NL

(71) Demandeur: GEMPLUS CARD INTERNATIONAL
15 avenue Camille Pelletan
F-13090 Aix en Provence (FR)

(72) Inventeur: Peres, Philippe
Cabinet Ballot-Schmit 84 avenue Kléber
F-75116 Paris (FR)

Deveaud, Vincent
Cabinet Ballot-Schmit 84 avenue Kléber
F-75116 Paris (FR)

(74) Mandataire: Ballot, Paul Denis Jacques
Cabinet Ballot-Schmit 84, avenue Kléber
F-75116 Paris (FR)

(54) Dispositif de protection électrostatique pour cartes électroniques.

(57) L'invention concerne un dispositif de protection électro-statique pour cartes électroniques.

La carte électronique possède un module (1) portant sur l'une de ses faces un réseau de pistes conductrices sur lequel est connecté au moins un circuit intégré. Sur l'autre face on trouve des contacts (5,5') accessibles de l'extérieur et reliés aux pistes conductrices. Chaque contact (5) est proche d'un contact (5') porté au potentiel de référence. Le contact (5') porte sur sa périphérie des excroissances (8') de métal placées en vis-à-vis d'autres excroissances (8) de métal portées par les contacts (5) de manière à favoriser la formation d'arcs électriques entre deux excroissances en vis-à-vis.

Application aux cartes électroniques.

FIG.1

EP 0 314 543 A1

Description

## DISPOSITIF DE PROTECTION ELECTROSTATIQUE POUR CARTES ELECTRONIQUES

La présente invention a pour objet un dispositif de protection contre les décharges électrostatiques de circuits intégrés montés en module et encartés sur un support électriquement isolant, portable tel qu'une carte électronique.

Un module est généralement composé de circuits intégrés tels que mémoires vives ou mortes, microprocesseurs ou circuits logiques connectés sur un support en utilisant soit une technologie dite "à fils", soit une technologie dite "TAB" pour Tape Automatic Bonding en langue anglaise.

Le support comporte sur l'une de ses faces un réseau de pistes conductrices. Le ou les circuits intégrés sont montés sur cette face. De petits fils conducteurs sont soudés respectivement sur les bornes d'entrée-sortie des circuits intégrés et sur la piste conductrice correspondant du support.

Sur l'autre face du support on trouve des contacts. Ils sont accessibles de l'extérieur et sont reliés chacun à une piste conductrice. Ils servent à assurer la liaison électrique entre les circuits intégrés et les organes extérieurs conçus pour dialoguer avec eux. Ces contacts transmettent aux circuits intégrés, par l'intermédiaire des pistes conductrices et des fils toutes les tensions qui y sont appliquées.

On dépose généralement une goutte de résine thermodurcissable sur les circuits intégrés et sur leurs connexions au support afin de les protéger. L'ensemble circuits intégrés et support forment le module qui est inséré dans un matériau isolant à la taille d'une carte électronique.

Les circuits intégrés utilisés dans ces cartes électroniques sont destinés à mémoriser, protéger et éventuellement faire des calculs sur des informations provenant de l'extérieur ou mémorisées par ceux-ci. Ils sont réalisés en technologie MOS (Metal Oxide Semiconductor ) ou CMOS (Complementary MOS). Ils sont sensibles aux décharges électrostatiques. Celles-ci peuvent, en effet endommager voire détruire les structures d'entrée, de sortie et les alimentations par claquage d'oxyde ou autre phénomène irréversible.

Les charges électrostatiques prennent naissance sur les contacts extérieurs sous l'action de divers frottements auxquels la carte risque d'être soumise ou bien par contact avec une personne elle-même chargée à un potentiel élevé.

Différentes solutions ont été adoptées afin de protéger les circuits intégrés contre les surtensions pour lesquels ils ne sont pas prévus. Une solution connue consiste à faire cotoyer systématiquement chaque contact extérieur du module, avec un contact porté au potentiel de référence.

Il est connu que la tension de claquage de l'aire est de l'ordre de 100000 Volts par centimètre. Les contacts sont généralement distants de quelques centaines de micromètres. Le fait de faire cotoyer chaque contact avec un contact porté au potentiel de référence, entraine lorsque la carte ou le module sont soumis à une décharge électrostatique, un arc électrique entre le contact exposé à la décharge et le contact porté au potentiel de référence. La surtension est ainsi atténuée et n'est pas transmise intégralement aux circuits intégrés.

La présente invention a pour but de réduire encore la surtension appliquée aux contacts, en proposant un dispositif favorisant les effets d'arcs et diminuant la tension minimale nécessaire pour avoir un arc.

Ainsi la présente invention a pour objet une carte électronique possédant un module constitué:
- d'un support isolant portant sur l'une de ses faces, un réseau de pistes conductrices et sur l'autre face, des contacts électriques accessibles de l'extérieur, placés de manière à ce chaque piste conductrice soit reliée à un contact et que chaque contact soit proche d'un contact porté au potentiel de référence;
- d'au moins un circuit intégré dont les bornes d'entrées et de sorties sont connectées au réseau de pistes conductrices caractérisée en ce que le contact porté au potentiel de référence porte sur sa périphérie plusieurs excroissances de métal placées en vis-à-vis d'autres excroissances de métal portées par les autres contacts de manière à protéger le ou les circuits intégrés contre les décharges électrostatiques.

D'autres caractéristiques ou avantages ressortiront de la description qui va suivre, faite en référence aux dessins annexés dans lesquels:

- La figure 1 est une vue de dessus partielle d'une carte électronique portant un module incluant le dispositif de protection selon l'invention.
- La figure 2 est une vue de dessous du même module.

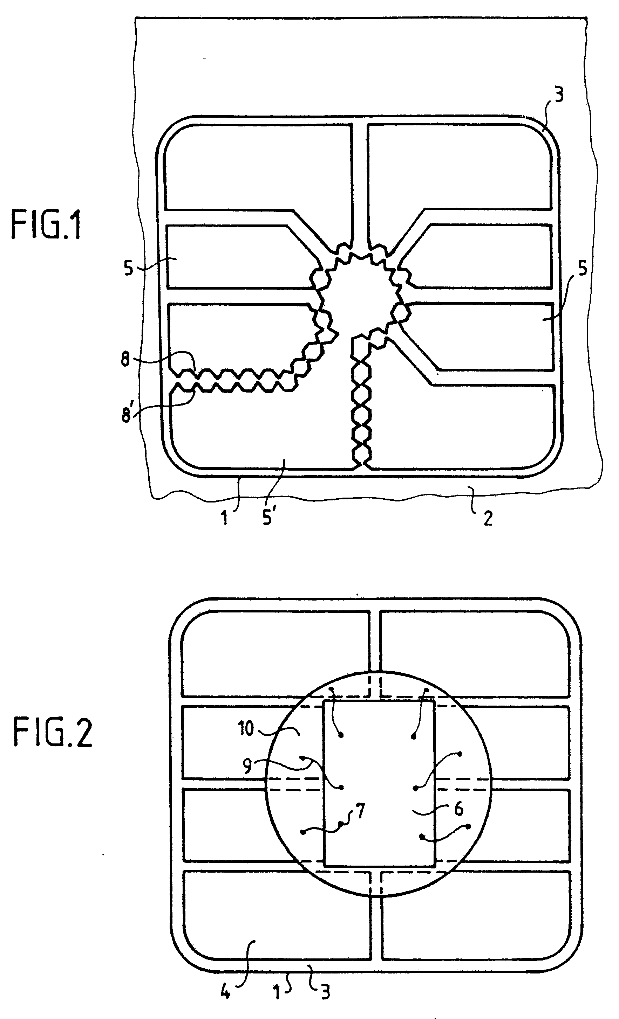

La carte représentée sur la figure 1 se compose d'un module 1 encarté sur un support 2 au format carte de crédit, par exemple.

Le module 1 est composé d'un support isolant 3 portant sur sa face inférieure, un réseau de pistes conductrices 4 visibles sur la figure 2. Chaque piste conductrice est reliée électriquement à un contact 5 porté par l'autre face du support 3 et visible sur la figure 1. Ces contacts sont accessibles de l'extérieur. Chaque contact 5 est proche d'un contact 5' porté au potentiel de référence. Ce contact 5' est également relié électriquement à une piste conductrice 4 portée au potentiel de référence.

Au moins un circuit intégré 6 est monté sur le support 3 sur la face portant le réseau de pistes conductrices. Les bornes d'entrées et de sorties 7 du circuit intégré sont connectées aux pistes conductrices 4 par l'intermédiaire de petits fils 9. Une goutte de résine 10 est déposée sur le circuit intégré 6 ainsi que sur les fils de connexion afin de les protéger.

Sur l'autre face du support 3 on trouve les contacts 5 et 5' accessibles de l'extérieur. Ils permettent la liaison entre la carte et les appareils conçus pour dialoguer avec elle.

La distance nominale entre deux contacts est de quelques centaines de micromètres. C'est entre un contact 5 et le contact 5' que prendra naissance un arc électrique quand la carte aura emmagasiné de l'électricité statique.

L'invention propose de diminuer la tension nécessaire pour la création d'un arc électrique, afin de protéger le circuit intégré contre une surtension. La tension de claquage de l'aire étant de 100000 Volts par centimètre, si la distance entre un contact 5 et le contact 5' est de 500 micromètres, la tension de claquage entre ces deux contacts sera de 5000 Volts. Pour diminuer cette tension, l'invention propose de réduire la distance nominale entre un contact 5 et le contact 5'. Pour cela le contact 5' porte sur sa périphérie plusieurs excroissances 8' de métal placées en vis-à-vis d'autres excroissances de métal 8 portées par les contacts 5. Ces excroissances de métal 8 et 8' placées en vis-à-vis réduisent la distance nominale entre les contacts 5 et 5' et diminuent la tension minimale pour obtenir un arc. De plus la forme pointue des excroissances favorise l'effet d'arc. C'est le principe de l'éclateur.

Dans notre exemple, la distance nominale entre l'extrémité de deux excroissances en vis-à-vis sera de moins de 100 micromètres. La tension de claquage sera de moins de 1000 Volts. Cette tension est supportée sans problème par un circuit intégré.

Il est conseillé de placer un maximum d'excroissances sur les contacts 5 et 5' car à force de subir l'action des arcs électriques les excroissances risquent de se dégrader.

La réalisation des contacts munis de leurs excroissances se fait par photogravure d'une couche métallique déposée sur le support.

Une telle protection contre les décharges électrostatiques prolonge de façon non négligeable la durée de vie d'une carte électronique.

## Revendications

1. Carte électronique possédant un module (1) constitué :
- d'un support isolant (3) portant sur l'une de ses faces,un réseau de pistes conductrices (4) et sur l'autre face, des contacts électriques (5,5') accessibles de l'extérieure, placés de manière à ce que chaque piste conductrice (4) soit reliée à un contact (5) et que chaque contact (5) soit proche d'un contact (5') porté au potentiel de référence,
- d'au moins un circuit intégré (6) dont les bornes d'entrées et de sorties sont connectées au réseau de pistes conductrices (4), caractérisée en ce que le contact (5') porté au potentiel de référence porte sur sa périphérie une ou plusieurs excroissances de métal (8') placées en vis-à-vis d'autres excroissances de métal (8) portées par les autres contacts (5) de manière à protéger le ou les circuits intégrés (6) contre les décharges électrostatiques.

2. Carte électronique selon la revendication 1, caractérisée en ce que la distance entre deux excroissances (8, 8') en vis-à-vis est inférieure à la distance nominale entre le contact (5') porté au potentiel de référence et les autres contacts (5).

3. Carte électronique selon les revendications 1 et 2 caractérisée en ce que les contacts (5, 5') et les excroissances (8, 8') sont réalisées par photogravure d'une couche métallique déposée sur le support.

FIG.1

FIG.2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | US-A-3 676 742  (L.K. RUSSELL) <br> * en entier * <br> --- | 1 | H 01 T    1/00 <br> H 02 H    9/06 |
| Y | DE-A-3 011 465  (HITACHI) <br> * pages 4 - 6, ligne 8; figures 1a - 3 * | 1 | |
| A | | 2 | |
| | --- | | |
| Y | DE-C-  762 743  (R. BOSCH GMBH) <br> * revendications 1 - 3, 15; figure 1 * | 1 | |
| A | | 3 | |
| | --- | | |
| A | DE-A-3 502 421  (PHILIPS) <br> * revendications 1, 4, 7 * <br> --- | 1 - 3 | |
| A | GB-A-2 046 539  (S.W. STAUBER GMBH) <br> * figures 1, 2 * <br> ----- | 1 | |

| DOMAINES TECHNIQUES RECHERCHES (Int. Cl.4) |
|---|
| H 01 T    1/00 <br> H 02 H    9/06 |

**Le présent rapport a été établi pour toutes les revendications**

| Lieu de la recherche | Date d'achèvement de la recherche | Examinateur |
|---|---|---|
| BERLIN | 16-01-1989 | LEMMERICH J |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant